**Europäisches Patentamt**

**European Patent Office**

**Office européen des brevets**

(11) Veröffentlichungsnummer: **0 204 168**
**B1**

(12) **EUROPÄISCHE PATENTSCHRIFT**

(45) Veröffentlichungstag der Patentschrift:
**27.12.90**

(51) Int. Cl.⁵: **H03H 9/145,** H03H 9/64, H03H 9/02

(21) Anmeldenummer: **86106225.5**

(22) Anmeldetag: **06.05.86**

(54) **Elektrisches Filter mit akustischen Wellen.**

(30) Priorität: **03.06.85 DE 3519853**

(43) Veröffentlichungstag der Anmeldung:
**10.12.86 Patentblatt 86/50**

(45) Bekanntmachung des Hinweises auf die Patenterteilung:
**27.12.90 Patentblatt 90/52**

(84) Benannte Vertragsstaaten:
**DE FR GB**

(56) Entgegenhaltungen:
**MATTHEWS: "Surface Wave Filters, Design, Construction and Use", Kapitel 3, Seiten 109-134, Verlag Wiley, New York, US; R.H. TANCRELL: "Principles of surface wave filter design"**

(73) Patentinhaber: **Siemens Aktiengesellschaft, Wittelsbacherplatz 2, D-8000 München 2(DE)**

(72) Erfinder: **Zibis, Peter, Dipl.-Ing., Kafkastrasse 14, D-8000 München 83(DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung bezieht sich auf ein elektrisches Filter, wie es im Oberbegriff des Patentanspruches 1 angegeben ist. Eine Anordnung mit zwei identisch gewichteten Wandlern ist angegeben in Fig. 7 in IEEE Trans. on Sonics and Ultrasonics, März 1975, S. 105 - 114.

Elektrische Filter mit in einem Substrat oberflächennah laufenden akustischen Wellen mit einem Eingangswandler und einem Ausgangswandler sind bekannt. Unter "oberflächennah laufenden ..." sind nicht nur Oberflächenwellen (Raleigh- und Bleustein-Wellen) im engeren Sinne, sondern auch Love-Wellen SSBW-, SBAW-Wellen und dgl. zu verstehen. Für derartige akustische Wellen ist es üblich, Finger- bzw. Elektrodenstrukturen zu verwenden, die je nach Zweckbestimmung ausgeführt auf der Oberfläche des erwähnten Substrats angeordnet sind. Derartige Fingerstrukturen, nämlich interdigitale Wandlerstrukturen, Reflektor-(Streifen-)Strukturen und weitere Strukturen wie Multistrip-Wandler und dgl. entsprechen in ihrer Anordnung, Dimensionierung und Ausgestaltung den durch die vorgegebene Übertragungsfunktion, Resonatorfunktion und dgl. bestimmten Vorgaben.

Für die Realisierung einer vorgegebenen Übertragungsfunktion ist die Anwendung der Finger-Überlappungswichtung bekannt, die darin besteht, daß die Finger der beiden ineinandergreifenden Kammstrukturen einer interdigitalen Wandlerstruktur mehr oder weniger große, gegenseitige Überlappungslänge aufweisen. Es ist üblich, nicht überlappende Fingerlängen durch Blindfingerlängen auszufüllen, um Gleichmäßigkeit der Oberflächenbelegung der Substratoberfläche mit Elektrodenfingern zu erreichen (siehe "Siemens Forschungs- und Entwicklungs-Berichte, Bd. 6 (1977), S. 132 - 136 (Fig. 5).

Im nachfolgenden werden hier in Frage kommende elektrische Filter mit akustischen Wellen zusammenfassend als Oberflächenwellenfilter bezeichnet, obwohl dieser Begriff auch enger verstanden wird.

Oberflächenwellenfilter, und zwar sowohl Transversalfilter als auch Resonatorfilter bzw. Resonatoren, werden meistenteils mit solchen Wandlern als Eingangswandler und Ausgangswandler versehen, von denen der eine Wandler eine solche Finger-Überlappungswichtung hat und der andere Wandler ein ungewichteter Wandler ist, d.h. dessen Finger-Überlappungen maximal und für alle Finger gleich sind. Eine solche Ausführungsform hat jedoch den Nachteil höherer Wichtungsverluste und höherer Einfügungsdämpfung, was insbesondere bei Resonatorfiltern besonders störend ist. Auch stören dort auftretende transversale Moden.

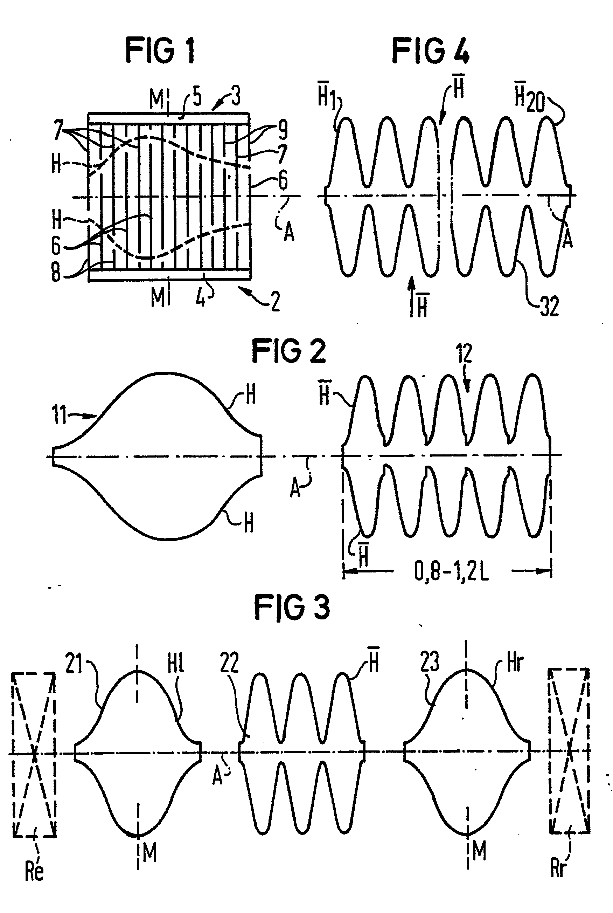

In ganz anderem Zusammenhang als mit der Erfindung ist aus Matthews, Surface Wave Filters, Design, Construction and Use, Verlag Wiley 1977, Fig. 3.13 auf Seite 134 ein Filter mit finger-überlappungsgewichtetem Eingangswandler und finger-überlappungsgewichtetem Ausgangswandler bekannt, wobei jedoch dieses Filter notwendigerweise einen Multistrip-Koppler und damit keinen Inline-Aufbau besitzt. Die Überlappungswichtung beider Wandler ist im übrigen wenigstens praktisch identisch.

Aus dem vorgenannten Buch ist außerdem aus den Seiten 131/132 ein Filter mit ebenfalls finger-überlappungsgewichtetem Eingangswandler und finger-überlappungsgewichtetem Ausgangswandler bekannt. Die Überlappungswichtungen beider Wandler sind wiederum wenigstens im wesentlichen identisch. Bei diesem Filter ist die Dimensionierung der Finger-Überlappungswichtungen von Eingangswandler und Ausgangswandler außerordentlich schwierig, da sie nur einer indirekten mathematischen Erfassung zugänglich ist und man bei dieser Dimensionierung relativ weitgehend auf Ausprobieren angewiesen ist. In der genannten Druckschrift ist dies neben weiteren Nachteilen angegeben.

Aufgabe der vorliegenden Erfindung ist es, ein Filter der einschlägigen Art anzugeben, das bei geringen Wichtungsverlusten und geringer Einfügungsdämpfung und weitgehender Unterdrückung transversaler Moden bei Verwendung als Resonator auf dem Wege eines in einfacher Weise zu erstellenden Designs zu entwerfen ist.

Diese Aufgabe wird mit einem elektrischen Filter gelöst, das die Merkmale des Patentanspruches 1 aufweist und weitere Ausgestaltungen und Weiterbildungen der Erfindung gehen aus den Unteransprüchen hervor.

Das erfindungsgemäße Filter hat Inline-Anordnung der Wandler. Im allgemeinen hat ein erfindungsgemäßes Filter einen Eingangswandler und einen Ausgangswandler. Es können aber auch z.B. zwei Eingangswandler und/oder zwei Ausgangswandler vorgesehen sein, z.B. zwei Eingangswandler bzw. zwei Ausgangswandler symmetrisch angeordnet zu einem Ausgangswandler bzw. Eingangswandler. Wegen dieses mehrfachen Vorhandenseins von Eingangswandlern bzw. Ausgangswandlern werden diese als "Wandlerarten" bezeichnet, wobei die eine Wandlerart die Gesamtheit der Eingangswandler und die andere Wandlerart die Gesamtheit der Ausgangswandler umfaßt. Der eine Wandler bzw. die eine Wandlerart (Eingangswandler oder Ausgangswandler) hat eine Finger-Überlappungswichtung, wie sie die vorgegebene Übertragungsfunktion bedingt, bzw. wie sie sich unter Anwendung der üblichen Entwurfstechnik mathematisch ergibt, und zwar unter Zugrundelegung eines (oder mehrerer) ungewichteter Wandler der anderen Wandlerart. Das heißt, der oder die Wandler der einen Wandlerart werden im Rahmen der Erfindung bei der Erstellung des Entwurfes so behandelt als wäre ein Filter der oben zum Stand der Technik an erster Stelle genannten Art zu entwerfen.

Bei der Erfindung wird das für den einen Wandler erstellte Entwurfsergebnis auch für den einen oder die mehreren Wandler der anderen Wandlerart berücksichtigt und diesem Wandler bzw. diesen Wandlern eine erfindungsgemäße Finger-Überlappungswichtung gegeben. Diese Finger-Überlappungswichtung der zweiten Wandlerart ist aber keineswegs identisch mit derjenigen der ersten Wandlerart. Für die andere Wandlerart ist eine Periodizität vorgesehen mit einer notwendigerweise wenigstens dreifachen Wiederholung des Finger-Überlappungsverlaufes der einen Wandlerart, d.h. eine periodische Wiederholung des Entwurfs vorzusehen. Dabei ist die Länge dieses bzw. der Wandler der anderen Wandlerart angenähert gleich der Länge desjenigen Wandlers, der als ungewichteter Wandler dem Entwurf der Wandler der ersten Wandlerart zugrundegelegt worden ist. Insbesondere liegt diese Längenabmessung zwischen dem 0,8 und 1,2- fachen der Länge diese zugrundegelegten ungewichteten Wandlers. Eine vernünftige obere Grenze für die Anzahl von Wiederholungen des Finger-Überlappungsverlaufes des Wandlers der ersten Wandlerart bei dem einen oder den mehreren Wandlern der zweiten Wandlerart liegt bei etwa der Zahl 20. Besonders günstig sind etwa 5 bis 10 Wiederholungen.

Weitere Erläuterungen der Erfindung werden insbesondere zum Zwecke noch besseren Verständnisses derselben durch eine anhand der Figur eines Ausführungsbeispiels gegebenen Beschreibung gemacht.

Figur 1 zeigt als erläuterndes Beispiel einen einzelnen finger-überlappungsgewichteten Interdigitalwandler.

Figuren 2 und 3 zeigen das Wichtungsprofil eines ersten und eines zweiten Ausführungsbeispiels eines erfindungsgemäßen Filters und die

Figur 4 zeigt mit einer unterbrochenen Darstellung für sich genommen einen Wandler der anderen Wandlerart mit 20 Wiederholungen.

Die Figur 1 zeigt einen einzelnen Interdigitalwandler, der aus zwei ineinandergreifenden Kammstrukturen 2 und 3 besteht. Mit 4 und 5 sind die Sammelschienen (Bus-Bars) bezeichnet. Die Finger 6 der Kammstruktur 2 sind mit der Sammelschiene 4 verbunden. Entsprechendes gilt für die Finger 7 der Kammstruktur 3 und der Sammelschiene 5. Wie ersichtlich, liegt jeweils eine Überlappung zwischen einem Finger 6 der einen Kammstruktur 2 und dem benachbarten Finger 7 der anderen Kammstruktur 3 vor. Diese Überlappungslängen sind durch die gestrichelt eingetragenen Hüllkurven H darstellungsgemäß hervorgehoben. Die zwischen den beiden Hüllkurven H befindliche Fläche des Interdigitalwandlers 3 bildet das Überlappungsprofil dieses Interdigitalwandlers. Je nach geforderter Übertragungsfunktion liegen bestimmte Überlappungsprofile vor. Insbesondere kann das Überlappungsprofil mit den Hüllkurven H (wie beim Interdigitalwandler der Figur 1) symmetrisch zur Achse A (Haupt-Wellenfortpflanzungsrichtung dieses Wandlers) sein. Das Beispiel der Figur 1 zeigt einen Wandler mit in Richtung der Achse A, bezogen auf die zur Achse A senkrechte Mittelebene M des Wandlers, nicht spiegelsymmetrisches Profil, d.h. der Wandler der Figur 1 hat diesbezüglich keine symmetrische Verteilung der Überlappungswichtungen. Die (in Figur 1 mit der Achse A zusammenfallende) Achse des Finger-Überlappungs-Profils kann auch in schräger Richtung oder auch in wechselnder Richtung durch den Wandler hindurch verlaufen. Solche Beispiele sind hinlänglich bekannt.

Der Wandler der Figur 1 hat zusätzlich noch Blindfinger 8 und 9, die ebenfalls mit der Sammelschiene 4 bzw. 5 verbunden sind. Da diese Blindfinger 8 und 9 keine Überlappung mit Fingerlängen von Fingern 7 bzw. 6 der jeweils anderen Kammstruktur aufweisen, sind diese Blindfinger 8, 9 elektrisch inaktiv. Man fügt sie jedoch dennoch in eine derartige Wandlerstruktur ein, um für die mechanischen Fortpflanzungsbedingunen der vom Wandler zu erzeugenden bzw. vom Wandler zu empfangenden Welle möglichst große Gleichmäßigkeit zu erreichen.

Ein erstes Ausführungsbeispiel der Erfindung zeigt Figur 2. Der Übersichtlichkeit halber ist von dem einen Wandler 11 (der einen Wandlerart) nur das Überlappungsprofil mit seinen Hüllkurven H dargestellt. Dieses Überlappungsprofil entspricht im wesentlichen demjenigen des Interdigitalwandlers der Figur 1. Mit 12 ist das erfindungsgemäß dazu angepaßte Überlappungsprofil des (zugehörigen) anderen Wandlers 12 (der anderen Wandlerart). Die Hüllkurven dieses Profils sind mit $\overline{H}$ bezeichnet. Das Profil dieses anderen Wandlers 12 weist fünf Wiederholungen des Verlaufs des Profils mit den Hüllkurven H des einen Wandlers 11 auf. Die Länge dieses anderen Wandlers 12 bemißt sich auf vorzugsweise 0,8 bis 1,2 mal der Länge des Wandlers, der für den Entwurf der Finger-Überlappungswichtung des Wandlers 11 zugrundegelegt wurde.

Wie auch aus der Figur ersichtlich, setzt sich die in Richtung der Achse A vorliegende (schon zur Figur 1 erläuterte) Unsymmetrie des Profils mit den Hüllkurven H im Wandler 12 der anderen Wandlerart fort, und zwar in axialer Richtung A lediglich vorschoben. An den Stoßstellen der Wiederholungen liegen daher die dargestellten Unstetigkeiten vor.

Wie üblich befinden sich die Wandler 11 und 12 auf einem für derartige elektrische Filter zu verwendenden Substratkörper. Alle weiteren Einzelheiten eines solchen Filters nach Figur 2 sind bekannter Art.

Der Wandler 11 kann Eingangswandler und der Wandler 12 dazu zugehörig der Ausgangswandler des Filters sein. Es kann aber auch der Wandler 12 der Eingangswandler und der Wandler 11 der Ausgangswandler sein.

Ein zweites Ausführungsbeispiel der Erfindung zeigt die Figur 3. Es ist dies ein Beispiel für ein Filter mit zwei Wandlern 21 und 23 der einen Wandlerart mit den miteinander übereinstimmenden Überlappungsprofilen mit den (ebenfalls übereinstimmenden) Einhüllenden Hl und Hr. Diese Wandler 21 und 23 befinden sich auf der Achse A des Filters ausgerichtet auf der einen Seite und auf der anderen Seite des Wandlers 22 der anderen Wandlerart. Dessen Überlappungsprofil geben die Einhüllenden $\overline{H}$ an. Bei einer solchen, bezogen auf den dargestellten Wandler 22 der anderen Wandlerart, symmetrischen Anordnung von Wandlern 21 und 23 der einen Wandlerart, ist ein bezogen auf die (bereits in Figur 1 definierte) Mittelebene M des Wandlers 21 bzw. 23 symmetrisches Profil der Finger-Überlappungswichtung vorzusehen. Es läßt sich dies durch entsprechende Ausgestaltung des Filterentwurfs für vorgegebene Übertragungsfunktion erreichen. Mit dieser zur angedeuteten Mittelebene M jeweils symmetrischen Verteilung ergibt sich keinerlei Problem für den Wandler 22 (der anderen Wandlerart), nämlich daß dessen Wiederholungen des Profils des einen Wandlers 21 bzw. 23 erfindungsgemäß eine Verschiebung in Richtung der Achse A (für den Wandler 21 nach rechts und für den Wandler 23 nach links) ist. Der Wandler 22 weist drei Wiederholungen des Profils des Wandlers 21 bzw. 23 auf. Wegen der Symmetrie entfällt hier auch die Unstetigkeit. Auch beim Filter der Figur 3 können die Wandler 21 und 23 Eingang und der Wandler 22 der Ausgang oder der Wandler 22 der Eingang und die Wandler 21 und 23 Ausgänge sein. Die Profile der Wandler 21 und 23 sind übereinstimmend.

Die Figur 3 zeigt gestrichelt dargestellt noch zwei Resonatorstrukturen Rl und Rr. Solche Reflektorstrukturen R werden in Resonatorfiltern bzw. Resonatoren verwendet, so daß Figur 3 auch die Alternative eines derartigen Filters zeigt.

Figur 4 zeigt, in Richtung der Achse A unterbrochen, einen Wandler 32 der anderen Wandlerart mit dem Profil mit den Hüllkurven $\bar{H}$. Das Vorhandensein von z.B. 20 Wiederholungen ist mit $\bar{H}_1$ bis $\bar{H}_{20}$ angedeutet. Diese $\bar{H}_1$ bis $\bar{H}_{20}$ sind erfindungsgemäß Wiederholungen des Profils H des zugehörigen nicht dargestellten Wandlers der einen Wandlerart.

Die Wandler 12 bzw. 22 (der anderen Wandlerart) haben eine vorzugsweise zwischen 0,8 bis 1,2 L betragende Länge (in Richtung der Achse A) bei einer Länge L des jeweils dem Entwurf für den zugehörigen Wandler 11 oder 21, 23 (der ersten Wandlerart) zugrundegelegten, ungewichteten Wandlers. Entsprechendes gilt für die Länge des Wandlers 32.

## Patentansprüche

1. Elektrisches Filter mit in einem Substrat oberflächennah laufenden akustischen Wellen,
mit wenigstens einem Eingangswandler als Wandler (11; 21, 23) einer ersten Wandlerart und mit wenigstens einem Ausgangswandler als Wandler (12; 22; 32) einer zweiten Wandlerart,
wobei diese beiden Wandler Finger-Überlappungswichtung aufweisen und inline-angeordnet sind,
**gekennzeichnet dadurch,**
- daß der (die) Wandler (11; 21, 23) der einen Wandlerart dasjenige durch die vorgegebene Übertragungsfunktion bestimmte Überlappungsprofil mit den Hüllkurven (H; Hl, Hr) der Finger-Überlappungen besitzt, die sich unter Zugrundelegung eines ungewichteten Wandlers als Wandler der anderen Wandlerart ergibt und
- daß der (die) Wandler (12; 22; 32) der anderen Wandlerart ein solches Überlappungsprofil mit Hüllkurven ($\bar{H}$) der Finger-Überlappungswichtung aufweisen, das eine wenigstens dreifache Wiederholung des Überlappungsprofils mit den Hüllkurven (H) des Wandlers bzw. der Wandler der einen Wandlerart ist,
- wobei die Länge des Wandlers (der Wandler) (12; 22; 32) der anderen Wandlerart wenigstens angenähert gleich der Länge (L) des bei der Erstellung des Entwurfs zugrundegelegten ungewichteten Wandlers ist.

2. Elektrisches Filter nach Anspruch 1, **gekennezeichnet dadurch,**
daß der (die) Wandler (21, 23) der einen Wandlerart, bezogen auf die Mittelebene (M) des Wandlers, jeweils ein Überlappungsprofil mit symmetrischen Hüllkurven (Hl, Hr) aufweist (-en). (Fig. 3)

3. Elektrisches Filter nach Anspruch 1, **gekennzeichnet dadurch,** daß der Wandler (11) der einen Wandlerart ein Überlappungsprofil mit, bezogen auf die Mittelebene (M) des Wandlers, unsymmetrischen Hüllkurven (H) hat (Fig. 1, 2).

4. Elektrisches Filter nach Anspruch 1 oder 2, **gekennzeichnet dadurch,** daß der (die) Wandler (12, 22, 32) der anderen Wandlerart eine zwischen 3 und 20 liegende Anzahl Wiederholungen des Überlappungsprofils des Wandlers der einen Wandlerart hat (Fig. 2, 3, 4).

5. Elektrisches Filter nach Anspruch 4, **gekennzeichnet dadurch,** daß diese Anzahl zwischen 5 und 10 liegt.

6. Elektrisches Filter nach Anspruch 1, 2, 4 und 5, **gekennzeichnet dadurch,** daß für die eine Wandlerart zwei Wandler (21, 23) und für die andere Wandlerart ein Wandler (22) vorgesehen ist, wobei sich der Wandler (22) der anderen Wandlerart zwischen den beiden Wandlern (21, 23) der einen Wandlerart angeordnet befindet (Fig. 3).

7. Elektrisches Filter nach Anspruch 1, 2, 4 und 5, **gekennzeichnet dadurch,** daß für die andere Wandlerart zwei Wandler und für die eine Wandlerart ein Wandler vorgesehen ist, wobei sich der Wandler der einen Wandlerart zwischen den beiden Wandlern der anderen Wandlerart angeordnet befindet.

8. Elektrisches Filter nach einem der Ansprüche 1 bis 7, **gekennzeichnet dadurch,** daß zusätzlich wenigstens eine Resonatorstruktur (Rl, Rr) vorgesehen ist.

9. Elektrisches Filter nach einem der Ansprüche 1 bis 8, **gekennzeichnet dadurch,** daß die Länge des bzw. der die Wiederholung des Überlappungsprofils aufweisenden Wandler (12, 22, 32) der anderen Wandlerart das 0,8 bis 1,2-fache des bei der Erstellung des Entwurf zugrundegelegten ungewichteten Wandlers beträgt.

## Claims

1. Electric filter with acoustic waves running near the surface in a substrate, comprising at least one input transducer as transducer (11; 21, 23) of a first transducer type and at least one output transducer as transducer (12; 22; 32) of a second transducer type, these two transducers having finger-overlap weightings and being arranged in an in-line fashion, characterized in that
- the transducer(s) (11; 21, 23) of the one transducer type has (have) that overlap profile with the envelopes (H; H1, Hr) of the finger overlaps that is determined by the prescribed transfer function which arises from assuming an unweighted transducer as tranducer of the other transducer type, and
- the transducer(s) (12; 22; 32) of the other transducer type has (have) an overlap profile with envelopes (H) of the finger-overlap weighting such that it is at least a three-fold repetition of the overlap profile with the envelopes (H) of the transducer or of the transducers of the one transducer type,
- the length of the transducer (the transducers) (12; 22; 32) of the other transducer type being at least approximately equal to the length (L) of the unweighted transducer forming the basis for producing the design.

2. Electric filter according to Claim 1, characterized in that the transducer(s) (21, 23) of the one transducer type in each case has (have) an overlap profile with symmetrical envelopes (H1, Hr) with reference to the centre plane (M) of the transducer (Fig. 3).

3. Electric filter according to Claim 1, characterized in that the transducer (11) of the one transducer type has an overlap profile with asymmetrical envelopes (H) with reference to the centre plane (M) of the transducer (Figs. 1, 2).

4. Electric filter according to Claim 1 or 2, characterized in that the transducer(s) (12, 22, 32) of the other transducer type has (have) a number of repetitions of the overlap profile of the transducer of the one transducer type that is between 3 and 20 (Figs. 2, 3, 4).

5. Electric filter according to Claim 4, characterized in that this number is between 5 and 10.

6. Electric filter according to Claims 1, 2, 4 and 5, characterized in that two transducers (21, 23) are provided for the one transducer type and one transducer (22) is provided for the other transducer type, the transducer (22) of the other transducer type being arranged situated between the two transducers (21, 23) of the one transducer type (Fig. 3).

7. Electric filter according to Claims 1, 2, 4 and 5, characterized in that two transducers are provided for the other transducer type and one transducer is provided for the one transducer type, the transducer of the one transducer type being arranged situated between the two transducers of the other transducer type.

8. Electric filter according to one of Claims 1 to 7, characterized in that, in addition, at least one resonator structure (R1, Rr) is provided.

9. Electric filter according to one of Claims 1 to 8, characterized in that the length of the transducer or transducers (12, 22, 32) of the other transducer type and having the repetition of the overlap profile is 0.8 to 1.2 times the length of the unweighted transducer forming the basis for producing the design.

**Revendications**

1. Filtre électrique à ondes acoustiques circulant à proximité de la surface dans un substrat, comprenant au moins un transducteur d'entrée constitué par un transducteur (11; 21; 23) d'un premier type, et au moins un transducteur de sortie constitué par un transducteur (12; 22; 32) d'un second type, ces deux transducteurs possédant une pondération par chevauchement des doigts et étant disposés en ligne, caractérisé par le fait
- que le ou les transducteurs (11; 21; 23) du premier type possèdent le même profil de chevauchement, déterminé par la fonction de transfert prédéterminée et présentant les courbes enveloppes (H; H1; Hr) des chevauchements des doigts, que celui que l'on obtient en prenant un transducteur non pondéré en tant que transducteur de l'autre type, et
- que le ou les transducteurs (12; 22; 32) de l'autre type possèdent un profil de chevauchement qui présente des courbes enveloppes (H) de la pondération par chevauchement des doigts et est une répétition au moins triple du profil de chevauchement présentant les courbes enveloppes (H) du ou des transducteurs du premier type,
- la longueur du transducteur (des transducteurs) (12; 22; 32) de l'autre type étant au moins approximativement égale à la longueur (L) du transducteur non pondéré pris pour base pour la réalisation du modèle.

2. Filtre électrique suivant la revendication 1, caractérisé par le fait que le ou les transducteurs (21, 23) du premier type possèdent respectivement un profil de chevauchement présentant des courbes enveloppes symétriques (H1; Hr) par rapport au plan médian (M) du transducteur (Figure 3).

3. Filtre électrique suivant la revendication 1, caractérisé par le fait que le transducteur (11) du premier type possède un profil de chevauchement présentant des courbes enveloppes (H) dissymétriques par rapport au plan médian (M) du transducteur (figures 1, 2).

4. Filtre électrique suivant la revendication 1 ou 2, caractérisé par le fait que le ou les transducteurs (12, 22, 32) de l'autre type possèdent un nombre, compris entre 3 et 20, de répétitions du profil de chevauchement du transducteur du premier type (figures 2, 3, 4).

5. Filtre électrique suivant la revendication 4, caractérisé par le fait que ce nombre est compris entre 5 et 10.

6. Filtre électrique suivant les revendications 1, 2, 4 et 5, caractérisé par le fait qu'il est prévu deux transducteurs (21, 23) d'un type et un transducteur (22) de l'autre type, le transducteur (22) de l'autre type étant disposé entre les deux transducteurs (21, 23) du premier type (Figure 3).

7. Filtre électrique suivant les revendications 1, 2, 4 et 5, caractérisé par le fait qu'il est prévu deux transducteurs de l'autre type et un transducteur du premier type, le transducteur du premier type étant situé entre les deux transducteurs de l'autre type.

8. Filtre électrique suivant l'une des revendications 1 à 7, caractérisé par le fait qu'il est prévu en supplément au moins une structure à résonateurs (R1, Rr).

9. Filtre électrique suivant l'une des revendications 1 à 8, caractérisé par le fait que la longueur du ou des transducteurs (12, 22, 32) de l'autre type, qui présentent la répétition du profil de chevauchement, est comprise entre 0,8 et 1,2 fois la longueur du transducteur non pondéré, pris pour base lors de la réalisation du modèle.

EP 0 204 168 B1

# FIG 1

# FIG 4

# FIG 2

0,8-1,2L

# FIG 3